# EUROPÄISCHE PATENTSCHRIFT

(11) **EP 1 854 907 B1**
(45) Veröffentlichungstag und Bekanntmachung des Hinweises auf die Patenterteilung: **29.02.2012**
(21) Anmeldenummer: 07008718.4
(22) Anmeldetag: 28.04.2007
(51) Int. Cl.: C23C 16/509, C23C 16/458, C23C 16/455, C23C 16/24, H01J 37/32, C03C 17/00

(54) **Vorrichtung zur plasmagestützten chemischen Oberflächenbehandlung von substraten im Vakuum**
Device for plasma-based chemical treatment of surfaces of substrates in a vacuum
Dispositif pour le traitement chimique sous vide assisté par plasma de la surface de substrats

(30) Priorität: 10.05.2006 DE 102006022799
(43) Veröffentlichungstag der Anmeldung: 14.11.2007
(73) Patentinhaber: Forschungs- und Applikationslabor Plasmatechnik GmbH Dresden, 01217 Dresden (DE)
(72) Erfinder: Stahr, Frank, Dr., 01477 Arnsdorf (DE); Steinke, Olaff, Dr., 01454 Liegau-Augustusbad (DE); Stephan, Ulf, Dr., 01309 Dresden (DE); Schade, Klaus, Prof., 01468 Moritzburg (DE)
(74) Vertreter: Pfenning, Meinig & Partner GbR

(56) Entgegenhaltungen:
- EP-A- 0 776 990
- WO-A-02/056338
- US-A- 5 113 790
- US-A- 5 632 873
- US-A- 6 051 122
- US-A1- 2004 159 286

## Beschreibung

Die Erfindung betrifft eine Vorrichtung zur plasmagestützten chemischen Oberflächenmodifizierung von Substraten im Vakuum. Dabei können mindestens eine Schicht auf eine Oberfläche von Substraten ausgebildet aber auch ein Abtrag von einer solchen Oberfläche vorgenommen werden. Sie kann besonders vorteilhaft bei großformatigen Substraten eingesetzt werden, da gleichzeitig große Oberflächen bearbeitet werden können.

Bei einer solchen Bearbeitung von Substraten, ohne dass die Substrate dabei bewegt, also statisch fixiert gehalten werden, ist eine Einhaltung homogener Verhältnisse über die gesamte zu modifizierende Oberfläche gewünscht. Dies betrifft die elektrischen Parameter, die Zusammensetzung der Atmosphäre und auch die Einhaltung möglichst konstanter Temperaturen unter Vermeidung größerer Temperaturgradienten.

Eine homogene Verteilung eines elektrischen Potentials kann mit einer hierfür günstigen Zuführung elektrischer Energie erreicht werden. Dies kann bei häufig eingesetzten planparallelen Elektrodensystemen mittels plattenförmiger Elektroden in einer Vakuumkammer erfolgen. Dabei ist in der Regel eine der Elektroden an Erdpotential angeschlossen und ein Substrat zwischen dieser und einer weiteren Elektrode angeordnet. Die an Erdpotential angeschlossene Elektrode kann gleichzeitig Träger von Substraten sein.

Die andere Elektrode ist an eine HF/VHF-Spannungsquelle ggf. aber auch an eine Gleichspannungsquelle angeschlossen.

Eine homogene Verteilung des elektrischen Potentials über die Oberfläche dieser Elektrode kann durch geeignete Dimensionierung der Elektrode oder auch die Einkopplung/Zuführung elektrischer Energie an mehreren Punkten, wie von U. Stephan; u.a. in "Large Area VHF-Plasma Processing of Silicon Alloys"; Proc. Of 16. EPSEC; Glasgow; May 2000; S. 533-536 veröffentlicht, erreicht werden.

Eine solche homogene Verteilung von elektrischem Potential ist aber auch an der anderen, an Erdpotential angeschlossen Elektrode sowie ein definierter elektrischer Stromfluss gewünscht

Bei den aus DE 100 10 016 C1 und US 4,798,739 bekannten Lösungen kann dies durch elektrische Kontaktierung eines metallischen Substratträgers, als eine Elektrode an eine Abschirmung der an eine Spannungsquelle angeschlossenen Elektrode, durch andrücken aneinander, erreicht werden. Die Abschirmung kann dabei ein Element eines Zwischenrezipienten sein.

Nachteilig dabei ist es aber, dass für die entsprechende Bewegung des Substrates mit dem als Elektrode geschalteten Substratträger in Richtung auf die an die elektrische Spannungsquelle angeschlossene Elektrode eine aufwändige Vorrichtung erforderlich ist und sich dabei auch die Vakuumbedingungen nachteilig auswirken. Außerdem unterscheiden sich die unter dem Einfluss von Plasma stehenden Flächen voneinander. Es treten eine von "Null" abweichende elektrische Eigengleichvorspannung (BIAS) und daher ein hoher Ladungsträgerbeschuss an Elektroden auf.

Diesen Problemen kann eigentlich durch geeignete Gestaltung von Vakuumkammer, Substrat und Elektroden entgegengetreten werden. Es liegt aber auf der Hand, dass dies für verschiedenste zu modifizierende Substrate innerhalb vorhandener Vakuumkammern und in der Regel für die Manipulation von Substraten innerhalb einer Vakuumkammer erforderlichen Transporteinrichtungen nicht oder nur begrenzt erreicht werden kann.

In DE 101 19 766 A1 und US 6,502,530 sind Systeme beschrieben, bei denen ein Gasverteiler an Erdpotential angeschlossen ist und dazu eine Elektrode mit Gasdusche elektrisch isoliert angeordnet ist, die eine seitliche Zuführung der hochfrequenten elektrischen Spannung aufweist. Ein wesentlicher Nachteil besteht dabei darin, dass vor allem bei hohen Frequenzen und/oder großen Elektrodenflächen inhomogene elektrische Potentialverteilungen und undefinierte Temperaturen an der Elektrode auftreten.

Aus US 2005 022735 A1 ist eine Vorrichtung zur Prozessgaseinkopplung bekannt, die von einer Elektrode mit Gasverteiler und Gasdusche thermisch und elektrisch isoliert ist. Damit kann zwar eine Wärmeableitung von der beheizten Gaszuführung verhindert werden, die Temperatur der Elektrode kann jedoch zeitlich nicht gesteuert beeinflusst werden.

Bei der aus US 4,989,543 bekannten Lösung kann ein Reaktor, als Zwischenrezipient im Vakuum von einer Heizung umgeben und dadurch auf eine konstante Temperatur gehalten sein. Ein Abführung von Wärme der exothermen Reaktion und der Teilchenbeschuss der Elektroden ist jedoch nicht in ausreichendem Maß möglich, so dass insbesondere bei Prozessen mit zugeführter elektrischer Leistungsdichte im Bereich von 1 W/cm² eine rasche Erwärmung und eine Deformation der das Plasma begrenzenden Elektroden auftreten. Dieser Nachteil tritt auch bei der in EP 0 476 480 A1 beschrieben Anordnung auf. Außerdem ändern sich in Abhängigkeit der Temperatur auch elektronische Eigenschaften von auf Substraten aufwachsenden Schichten. Bei temperaturempfindlichen Substraten, wie Polymeren kann eine solche Temperaturerhöhung zu einer merklichen Schädigung solcher Substrate führen.

Es ist daher Aufgabe der Erfindung eine Möglichkeit zu schaffen, um günstigere elektrische Verhältnisse bei der Modifizierung von Substratoberflächen im Vakuum durch einen verbesserten elektrischen Stromfluss, zu erreichen.

Erfindungsgemäß wird diese Aufgabe mit einer Vorrichtung, die die Merkmale des Anspruch 1 aufweist, gelöst. Vorteilhafte Ausgestaltungen und Weiterbildungen der Erfindung können mit in untergeordneten Ansprüchen bezeichneten technischen Merkmalen erreicht werden.

Bei der erfindungsgemäßen Vorrichtung sind innerhalb einer Vakuumkammer ein Substrat auf einem aus einem elektrisch leitenden Werkstoff gebildeten Substratträger sowie zumindest ein Teil einer Elektrodeneinheit angeordnet. Die Elektrodeneinheit ist parallel zur zu modifizierenden Oberfläche des Substrates ausgerichtet und an eine HF/VHF-Spannungsquelle elektrisch leitend angeschlossen.

Außerdem soll über die Elektrodeneinheit ein Reaktionsgas zur Plasmabildung und Oberflächenmodifizierung in einen zwischen Elektrodeneinheit und Substrat angeordneten Plasmareaktionsraum eingeführt werden.

Der Plasmareaktionsraum ist von einer elektrischen Abschirmung an seinem radial äußeren Rand umschlossen, an Erdpotential angeschlossen und elektrisch leitend über die Elektrodeneinheit mit der HF/VHF-Spannungsquelle verbunden. Außerdem ist ein Kontaktrahmen vorhanden, der elektrisch leitend mit der Abschirmung verbunden ist. Der Kontaktrahmen kann dabei bewegt werden. Durch eine Bewegung des Kontaktrahmens in Richtung auf Substrat und Substratträger kann beim Betrieb der Vorrichtung eine elektrische leitende Verbindung von Kontaktrahmen und Substratträger hergestellt werden. Dies bedeutet, dass Kontaktrahmen und Substratträger elektrisch leitend miteinander verbunden sind, wenn eine Oberflächenmodifizierung von Substraten bei gleichzeitig gebildetem Plasma durchgeführt wird. Diese Verbindung kann dann durch eine entgegengesetzt gerichtete Bewegung des Kontaktrahmens wieder getrennt werden. Dadurch werden Substrat mit Substratträger wieder frei gegeben und können nach einer durchgeführten Oberflächenmodifizierung wieder aus der Vakuumkammer entfernt werden.

Durch den erfindungsgemäß vorhanden beweglichen Kontaktrahmen kann neben einer definierten Begrenzung des Plasmareaktionsraumes und der darin erfolgenden Gasentladung auch ein definiertes elektrisch wirksames Flächenverhältnis der beiden Elektroden, nämlich der Elektrodeneinheit und dem Substratträger eingehalten werden. Durch die lokale Eingrenzung der zur Plasmabildung führenden Gasentladung können parasitäre Beschichtungen oder Ätzungen innerhalb von Vakuumkammern reduziert oder gar vermieden werden.

Vorteilhaft ist es, den Kontaktrahmen so auszubilden, dass er zum einen elektrisch leitend und auch elektrisch nicht leitend ist. Hierzu sollte er so ausgebildet sein, dass die erforderliche elektrisch leitende Verbindung zwischen elektrisch leitendem Substratträger und der Abschirmung erreicht wird. Die kann mit einzelnen stab- oder plattenförmigen Elementen erreicht werden, über die ein elektrischer Stromfluss erfolgen kann. Diese stab- oder plattenförmigen Elemente können in einen elektrisch nicht leitenden Werkstoff eingebettet sein. So kann die in das Innere des Plasmareaktionsraums weisende Wand des Kontaktrahmens elektrisch nicht leitend sein. Es besteht aber auch die Möglichkeit die innere Wand des Kontaktrahmens mit einem elektrisch nicht leitenden Stoff zu beschichten oder dort eine solche Auskleidung vorzusehen.

Dadurch kann ein den Modifizierungsprozess negativ beeinträchtigender elektrischer Stromfluss zwischen Gasentladung im Plasmareaktionsraum zum Kontaktrahmen vermieden werden.

Außerdem ist es günstig einen Anschluss mit Absaugkanal für Reaktionsprodukte vorzusehen. Dieser sollte gasförmige Reaktionsprodukte, mit denen auch gebildete Partikel abgeführt werden können, aus dem Plasmareaktionsraum abführen. Der Absaugkanal kann hierfür zwischen Abschirmung und einer Wand der Vakuumkammer angeschlossen sein bzw. dort einmünden.

Zwischen Kontaktrahmen und Gasentladung treten Wechselwirkungen auf. Dabei kann ein elektrischer Stromfluss auftreten und die elektrisch wirksame Fläche der Elektrode vergrößert sich. Dies kann aber durch eine elektrisch nicht leitende Ausbildung eines Kontaktrahmens in Richtung des Plasmareaktionsraums, wie vorab erläutert vermieden werden.

Auf diese Weise können elektrisch symmetrische Verhältnisse im Bereich der Elektroden (Elektrodeneinheit - Substratträger) eingehalten werden, da eine Eigengleichvorspannung zumindest nahe 0 Volt realisierbar ist, was zu einem verringerten Beschuss von Elektrodenflächen und Substrat mit hochenergetischen Ladungsträgern führt.

Insbesondere unter Berücksichtigung der Einhaltung homogener Temperaturverhältnisse bei der Oberflächenmodifizierung über die gesamte zu modifizierende Oberfläche von Substraten, ist es vorteilhaft eine Elektrodeneinheit, die aus mehreren miteinander verbundenen plattenförmigen Elementen gebildet ist, einzusetzen. Dabei sollten sich die plattenförmigen Elemente flächig berühren.

Zumindest ein Teil der Elektrodeneinheit kann dabei einen Teil der Wandung der Vakuumkammer bilden. Hierzu kann die Elektrodeneinheit in eine entsprechende Aufnahme der Wandung der Vakuumkammer eingesetzt sein. Dabei ist eine vakuumdichte Abdichtung an der Elektrodeneinheit zwischen Vakuumkammer und Umgebung erforderlich. Außerdem sollte eine elektrische Isolierung zwischen Elektrodeneinheit und Wandung der Vakuumkammer vorhanden sein.

Die Elektrodeneinheit ist so von der Umgebungsseite unter Umgebungsdruckbedingungen zugänglich, so dass auf einige aufwändige Vakuumdurchführungen verzichtet werden kann und der elektrische Anschluss zu einer HF/VHF-Spannungsquelle von außen an die Elektrodeneinheit gelegt sein. Dies ist insbesondere bei einer Mehrfacheinspeisung über mehrere lokal verteilte elektrische Anschlusskontakte vorteilhaft.

Eine so ausgebildete und angeordnete Elektrodeneinheit kann so auch von außen temperiert werden, da eine Temperiereinrichtung ebenfalls außerhalb der Vakuumkammer bei Umgebungsdruckbedingungen installiert werden kann.

Ein äußeres plattenförmiges Element der Elektrodeneinheit kann dabei wannenförmig ausgebildet sein, wobei die Öffnung der Wanne nach außen weisen kann.

Das äußere plattenförmige Element kann mit mindestens zwei weiteren plattenförmigen Elementen verbunden sein.

Diese beiden oder auch mehrere plattenförmigen Elemente bilden zusätzlich einen Verteiler für Reaktionsgas, das dem Plasmareaktionsraum zugeführt werden soll. Hierzu sind mit den plattenförmigen Elementen Kanäle ausgebildet über die von mindestens einer Zuführung Reaktionsgas eingespeist, verteilt und über eine Mehrzahl von Austrittsöffnungen in den Plasmareaktionsraum eingeführt werden kann. Austrittsöffnungen sind dabei im plattenförmigen Element der Elektrodeneinheit, die in Richtung auf den Plasmareaktionsraum angeordnet ist, ausgebildet.

Kanäle für die Verteilung von Reaktionsgas zu Austrittsöffnungen können mittels nutenförmiger Aussparungen, die an mindestens einem dieser beiden plattenförmigen Elemente ausgebildet sind, hergestellt worden sein, die dann von der Ober- und Unterseite der miteinander verbundenen plattenförmigen Elemente abgeschlossen sind.

Alle plattenförmigen Elemente können mit Wärmeleitkontaktelementen verbunden sein, die möglichst über die Fläche homogen verteilt angeordnet sein sollten. Dabei können gemeinsam zwei oder gleich alle drei plattenförmigen Elemente der Elektrodeneinheit mit Wärmeleitkontaktelementen verbunden sein.

So können zwei oder auch drei plattenförmige Elemente mit Schrauben oder Nieten, als Wärmeleitkontaktelemente verbunden sein.

Die plattenförmigen Elemente der Elektrodeneinheit und/oder die Wärmeleitkontaktelemente sollten aus Werkstoffen mit guter Wärmeleitfähigkeit gebildet sein. Dies können geeignete Metalle oder auch Legierungen sein. Bevorzugt können Wärmeleitkontaktelemente aus einem Werkstoff mit höherer Wärmeleitfähigkeit eingesetzt werden, als dem Werkstoff aus dem die plattenförmigen Elemente gebildet sind.

Für eine gleichmäßige Temperaturverteilung bei der Oberflächenmodifizierung kann es auch günstig sein, die Wärmeleitkontaktelemente und Austrittsöffnungen für Reaktionsgas äquidistant zueinander anzuordnen. So können die Abstände benachbart zueinander angeordneter Austrittsöffnungen jeweils gleich sein. Dies kann auch auf die Abstände benachbarter Wärmeleitkontaktelemente und ggf. auch sämtlicher Abstände zwischen Austrittsöffnungen und Wärmeleitkontaktelementen zutreffen.

Mit der Erfindung kann eine verbesserte Reproduzierbarkeit von Oberflächenmodifizierungsprozessen, bei erhöhter thermischer Langzeitstabilität erreicht werden. Dabei ist auch die definierte homogene elektrisch Spannungs- oder auch Stromverteilung vorteilhaft.

Es kann bei erhöhten Leistungsdichten gearbeitet werden und dabei die erforderliche Bearbeitungszeit verkürzt werden.

Außerdem können die Erfordernisse an den konstruktiven Aufbau von Substratträgern und deren Transportsystemen reduziert werden.

Nachfolgend soll die Erfindung beispielhaft näher erläutert werden.

### Dabei zeigt:

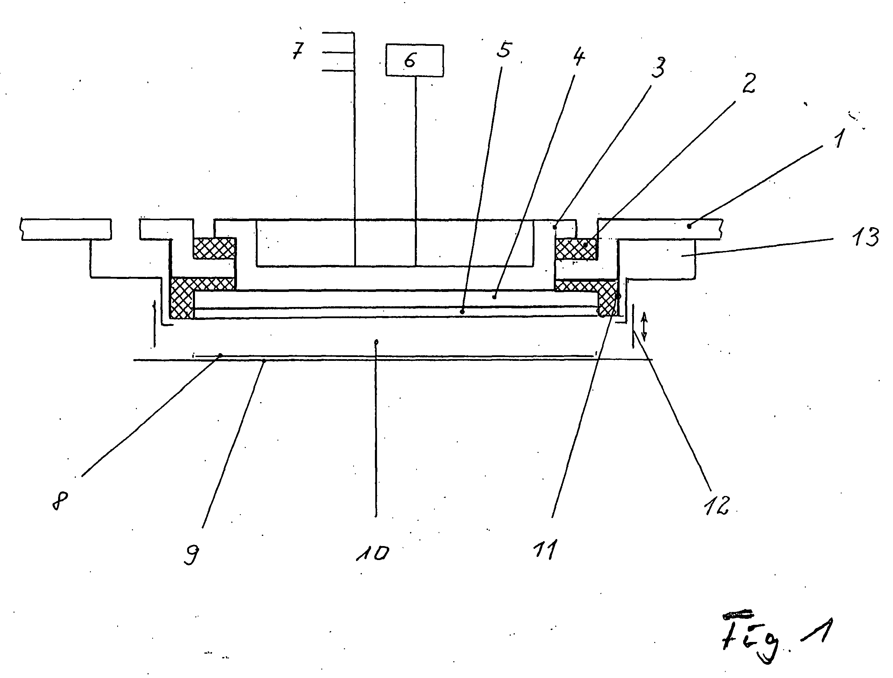

Figur 1 ein Beispiel einer erfindungsgemäßen Vorrichtung in schematischer Darstellung.

In Figur 1 ist lediglich ein Teil der oberen Wand 1 einer Vakuumkammer gezeigt. Darin ist eine Aussparung vorgesehen, durch die eine aus hier drei plattenförmigen Elementen 3, 4 und 5 gebildete Elektrodeneinheit eingeführt und an der Vakuumkammer vakuumdicht fixiert ist. Zu deren elektrischer Isolation ist eine elektrische Isolierung 2 umlaufend zwischen Wand 1 und dem äußeren plattenförmigen Element 3 vorhanden.

Bei diesem Beispiel ist das äußere plattenförmige Element 3 wannenförmig ausgebildet, dessen offene Seite nach außen weist und unter Umgebungsbedingen steht. Über einen oder ggf. auch mehrere Anschlusskontakte ist das äußere plattenförmige Element 3 mit einer HF/VHF-Spannungsquelle 6 verbunden. Der eine oder auch mehrere über die Fläche des plattenförmigen Elementes 3 verteilte Anschlusskontakt(e) sind ebenfalls der Umgebung der Vakuumkammer ausgesetzt und unterliegen dadurch keinen Vakuumerfordernissen. Dies trifft auch auf eine Reaktionsgaszuführung 7 zu, die ebenfalls bis zur nach außen weisenden Oberseite des äußeren plattenförmigen Elementes 3 und von dort zu einem zur Verteilung von Reaktionsgas mit den beiden weiteren plattenförmigen Elementen 4 und 5 gebildeten Gasverteiler geführt ist.

In nicht dargestellter Form kann auch mindestens noch eine weitere Zuführung für ein weiteres Reaktionsgas vorgesehen sein.

Insbesondere das äußere hier wannenförmig ausgebildete plattenförmige Element 3, möglichst aber auch die beiden anderen plattenförmigen Elemente 4 und 5 sowie nicht dargestellte, im allgemeinen Teil der Beschreibung aber hinlänglich erläuterte Wärmeleitkontaktelemente sollen aus Werkstoffen erhöhter Wärmeleitfähigkeit hergestellt worden sein.

Das äußere plattenförmige Element 3 bildet quasi eine Schnittstelle zwischen Umgebungsatmosphäre und Vakuum.

Von der HF/VHF-Spannungsquelle 6 kann eine elektrische Spannung mit einer Frequenz von z.B. 13,56 MHz zu Verfügung gestellt und an die Elektrodeneinheit angeschlossen sein.

Als Reaktionsgas können übliche Gase, wie auch Gasgemische, z.B. SiH₄/H₂ dem Plasmareaktionsraum 10 zugeführt werden.

In nicht dargestellter Form kann eine Temperiereinrichtung bevorzugt von außen auf das äußere plattenförmige Element 3 aufgesetzt sein. Mit einer solchen Temperiereinrichtung kann dann Wärmeenergie abgeführt werden, wobei dies über die gesamte Fläche sehr gleichmäßig möglich ist, so dass lokale Temperaturgradienten vermieden ggf. auftretende jedoch zumindest klein gehalten werden können.

Die drei miteinander flächig verbundenen plattenförmigen Elemente 3, 4 und 5 sind nicht nur für eine über die Fläche gleichmäßige Verteilung elektrischer Paramter, einer solchen Verteilung von dem Plasmareaktionsraum 10 zugeführtem Reaktionsgas, sondern auch für eine gleichmäßige Temperaturverteilung vorteilhaft.

Es konnten Temperaturverteilungen über die gesamte Fläche der Elektrodeneinheit von ca. 1 m² mit einer erfindungsgemäßen Vorrichtung mit Abweichungen von maximal 2% und eine Schichtdickenkonstanz bei einer auf einer Substratoberfläche bei einer Schicht aus a-Si:H über diese Fläche von 2,5 % eingehalten werden.

Aus Figur 1 wird weiter deutlich, dass zusätzlich eine den Plasmareaktionsraum 10 umschließende Abschirmung 11 vorhanden ist, die elektrisch leitend mit der Wand 1 der Vakuumkammer und ebenfalls mit der HF/VHF-Spannungsquelle 6 verbunden ist.

An der Abschirmung 11 ist ein Kontaktrahmen 12 befestigt und ebenfalls elektrisch leitend mit der Abschirmung 11 verbunden.

Der Kontaktrahmen 12 ist dabei so befestigt, dass er in Richtung auf den hier metallischen Substratträger 9 bewegt werden kann, wenn die Vorrichtung in Betrieb ist. Dies ist mit dem Doppelpfeil angedeutet.

Beim Betrieb der Vorrichtung kann so eine elektrisch leitende Verbindung zwischen Substratträger 9, auf dem ein an einer Oberfläche zu modifizierendes Substrat 8 angeordnet ist, dem Kontaktrahmen 12, der Abschirmung 11, Wand 1 der Vakuumkammer und auch HF/VHF-Spannungsquelle 6 hergestellt werden.

Der Kontaktrahmen 12 ist hier mit einer keramischen, elektrisch nicht leitenden Beschichtung an der in Richtung des Plasmareaktionsraums 10 weisenden Oberfläche versehen worden und an der Außenseite aus Aluminium gebildet, die den elektrischen Leiter bildet

Außerdem ist mindestens ein Absaugkanal 13 vorhanden, über den gebildete Reaktionsprodukte abgeführt werden können. Dieser mündet in den Bereich zwischen Abschirmung 11 und Plasmareaktionsraum 10. Dabei kann die Mündung umlaufend um den gesamten Plasmareaktionsraum 10 ausgebildet sein.

Auf die Darstellung von Austrittsöffnungen für Reaktionsgas(e) und Wärmeleitkontaktelemente, wie sie ebenfalls im allgemeinen Teil der Beschreibung ausführlich erläutert worden sind, ist aus Übersichtlichkeitsgründen in Figur 1 verzichtet worden.

## Patentansprüche

1. Vorrichtung zur plasmagestützten chemischen Oberflächenmodifizierung von Substraten im Vakuum, bei der in einer Vakuumkammer ein Substrat (8) auf einem aus einem elektrisch leitenden Werkstoff gebildeten Substratträger (9) angeordnet ist, parallel zur Substratoberfläche,eine Elektrodeneinheit (3, 4, 5) vorhanden ist, die an eine HF/VHF-Spannungsquelle (6) angeschlossen ist und über die Elektrodeneinheit (3, 4, 5 zur Plasmabildung und Oberflächenmodifizierung ein Reaktionsgas in einen zwischen Elektrodeneinheit (3, 4, 5) und Substrat (8) angeordneten Plasmareaktionsraum (10) zugeführt wird, wobei der Plasmareaktionsraum (10) von einer elektrischen Abschirmung (11) an seinem radial äußeren Rand umschlossen, an Erdpotential angeschlossen sowie elektrisch leitend über die Elektrodeneinheit (3, 4, 5) mit der HF/VHF-Spannungsquelle (6) verbunden ist; außerdem ist ein Kontaktrahmen (12) mit der elektrischen Abschirmung (11) elektrisch leitend und beweglich verbunden, so dass beim Betrieb der Vorrichtung eine elektrisch leitende Verbindung des Kontaktrahmens (12) mit dem Substratträger (9) hergestellt ist.

2. Vorrichtung nach Anspruch 1, **dadurch gekennzeichnet, dass** der Kontaktrahmen (12) auf der in Richtung Plasmareaktionsraum (10)weisenden Seite mit einer elektrisch nicht leitenden Beschichtung oder mit einer elektrisch nicht leitenden Auskleidung versehen ist.

3. Vorrichtung nach Anspruch 1 oder 2, **dadurch gekennzeichnet, dass** an den Plasmareaktionsraum (10) mindestens ein Absaugkanal (13) für Reaktionsprodukte angeschlossen ist.

4. Vorrichtung nach Anspruch 3, **dadurch gekennzeichnet, dass** der Absaugkanal (13) zwischen Abschirmung (11) und einer Wand (1) der Vakuumkammer einmündet.

5. Vorrichtung nach einem der vorhergehenden Ansprüche, **dadurch gekennzeichnet, dass** die Elektrodeneinheit aus sich flächig berührenden und miteinander verbundenen plattenförmigen Einzelelementen (3, 4, 5) gebildet ist.

6. Vorrichtung nach Anspruch 5, **dadurch gekennzeichnet, dass** die Elektrodeneinheit (3, 4, 5) einen Teil der äußeren Wandung der Vakuumkammer bildet.

7. Vorrichtung nach Anspruch 5 oder 6, **dadurch gekennzeichnet, dass** ein äußeres plattenförmiges Element (3) elektrisch leitend mit der HF/VHF-Spannungsquelle (6) verbunden und durch eine elektrisch nicht leitende Isolierung (2) von der übrigen Wandung (1) der Vakuumkammer getrennt ist.

8. Vorrichtung nach einem der Ansprüche 5 bis 7, **dadurch gekennzeichnet, dass** eine Gasverteilung mit Gasaustrittsöffnungen in den Plasmareaktionsraum (10) mit mindestens zwei miteinander verbundenen plattenförmigen Elementen (4 und 5) der Elektrodeneinheit ausgebildet und die plattenförmigen Elemente (4 und 5) mit dem äußeren plattenförmigen Element (3) verbunden sind.

9. Vorrichtung nach einem der vorhergehenden Ansprüche, **dadurch gekennzeichnet, dass** das plattenförmige Element (3) wannenförmig ausgebildet ist.

10. Vorrichtung nach einem der vorhergehenden Ansprüche, **dadurch gekennzeichnet, dass** die plattenförmigen Elemente (3, 4, 5) mit über die Fläche homogen verteilten Wärmeleitkontaktelementen miteinander verbunden sind.

11. Vorrichtung nach einem der Ansprüche 5 bis 10, **dadurch gekennzeichnet, dass** am äußeren plattenförmigen Element (3) eine Temperiereinrichtung angeordnet ist.

12. Vorrichtung nach Anspruch 11, **dadurch gekennzeichnet, dass** die Temperiereinrichtung außerhalb der Vakuumkammer in einem Bereich mit Umgebungsdruck angeordnet ist.

13. Vorrichtung nach einem der Ansprüche 5 bis 12, **dadurch gekennzeichnet, dass** ein oder mehrere elektrische Anschlusskontakte von der HF/VHF-Spannungsquelle (6) am äußeren plattenförmigen Element (3) außerhalb der Vakuumkammer angeordnet ist/sind.

14. Vorrichtung nach einem der Ansprüche 5 bis 13, **dadurch gekennzeichnet, dass** die plattenförmigen Elemente (3, 4, 5) und/oder die Wärmeleitkontaktelemente aus einem Werkstoff mit hoher Wärmeleitfähigkeit gebildet sind.

15. Vorrichtung nach einem der Ansprüche 5 bis 14, **dadurch gekennzeichnet, dass** die Wärmeleitkontaktelemente Nieten und/oder Schrauben sind.

16. Vorrichtung nach einem der Ansprüche 5 bis 15, **dadurch gekennzeichnet, dass** die Wärmeleitkontaktelemente und die plattenförmigen Elemente (3, 4, 5) der Elektrodeneinheit aus dem gleichen Werkstoff gebildet sind.

17. Vorrichtung nach einem der Ansprüche 5 bis 16, **dadurch gekennzeichnet**, das an der Elektrodeneinheit (3, 4, 5) Wärmeleitkontaktelemente und Austrittsöffnungen für Reaktionsgas in ded Plasmareaktionsraum (10) jeweils äquidistant zueinander angeordnet sind.

## Claims

1. A device for plasma-based chemical modification of surfaces of substrates in a vacuum, in which a substrate (8) in a vacuum chamber is arranged on a substrate support (9) made from an electrically conductive material, an electrode unit (3, 4, 5) is provided parallel to the substrate surface and is connected to an HF/VHF voltage source (6) and, for the purpose of plasma formation and surface modification, a reaction gas is supplied by way of the electrode unit (3, 4, 5) to a plasma reaction space (10) which is arranged between the electrode unit (3, 4, 5) and the substrate (8), wherein the plasma reaction space (10) is surrounded by an electrical shield (11) on its radially outer edge, is connected to earth potential and is connected in electrically conductive manner to the HF/VHF voltage source (6) by way of the electrode unit (3, 4, 5); further, a contact frame (12) is connected movably and in electrically conductive manner to the electrical shield (11) such that when the device is operated an electrically conductive connection is made between the contact frame (12) and the substrate support (9).

2. A device according to Claim 1, **characterised in that** the contact frame (12) is provided, on the side facing in the direction of the plasma reaction space (10), with an electrically non-conductive coating or an electrically non-conductive cladding.

3. A device according to Claim 1 or 2, **characterised in that** at least one suction duct (13) for taking away reaction products is connected to the plasma reaction space (10).

4. A device according to Claim 3, **characterised in that** the opening to the suction duct (13) is between the shield (11) and a wall (1) in the vacuum chamber.

5. A device according to one of the preceding claims, **characterised in that** the electrode unit is formed by plate-shaped individual elements (3, 4, 5) which are in surface contact and connected to one another.

6. A device according to Claim 5, **characterised in that** the electrode unit (3, 4, 5) _ forms part of the outer wall of the vacuum chamber.

7. A device according to Claim 5 or 6, **characterised in that** an outer plate-shaped element (3) is connected in electrically conductive manner to the HF/VHF voltage source (6) and is isolated from the rest of the wall (1) of the vacuum chamber by an electrically non-conductive insulation means (2).

8. A device according to one of Claims 5 to 7, **characterised in that** a gas distribution means having gas exit openings coming into the plasma reaction space (10) is constructed with at least two mutually connected plate-shaped elements (4 and 5) of the electrode unit, and the plate-shaped elements (4 and 5) are connected to the outer plate-shaped element (3).

9. A device according to one of the preceding claims, **characterised in that** the plate-shaped element (3) is constructed to be trough-shaped.

10. A device according to one of the preceding claims, **characterised in that** the plate-shaped elements (3, 4, 5) are connected to one another by way of thermally conductive contact elements which are homogeneously distributed over the surface.

11. A device according to one of Claims 5 to 10, **characterised in that** a tempering unit is arranged on the outer plate-shaped element (3).

12. A device according to Claim 11, **characterised in that** the tempering unit is arranged outside the vacuum chamber in a region of atmospheric pressure.

13. A device according to one of Claims 5 to 12, **characterised in that** one or more electrical connection contacts of the HF/VHF voltage source (6) is/are arranged on the outer plate-shaped element (3), outside the vacuum chamber.

14. A device according to one of Claims 5 to 13, **characterised in that** the plate-shaped elements (3, 4, 5) and/or the thermally conductive contact elements are made from a material of high thermal conductivity.

15. A device according to one of Claims 5 to 14, **characterised in that** the thermally conductive contact elements are rivets and/or screws.

16. A device according to one of Claims 5 to 15, **characterised in that** the thermally conductive contact elements and the plate-shaped elements (3, 4, 5) of the electrode unit are made from the same material.

17. A device according to one of Claims 5 to 16, **characterised in that** thermally conductive contact elements and exit openings for reaction gas into the plasma reaction space (10) are arranged on the electrode unit (3, 4, 5), in each case equidistant from one-another.

## Revendications

1. Dispositif de modification chimique de surface de substrats, sous vide et assistée par plasma" dans lequel, dans une chambre à vide, un substrat (8) est agencé sur un porte-substrat (9) formé d'un matériau électroconducteur, une unité d'électrodes (3, 4, 5) est présente parallèlement à la surface de substrat, laquelle unité d'électrodes est reliée à une source de tension HF/VHF (6) et, via l'unité d'électrodes (3, 4, 5) et à des fins de formation de plasma et de modification de surface, un gaz de réaction est acheminé dans un espace de réaction au plasma (10) agencé entre l'unité d'électrodes (3, 4, 5) et le substrat (8), dans lequel l'espace de réaction au plasma (10) est entouré par un blindage électrique (11) sur son bord radialement externe, branché au potentiel de terre ainsi que relié par voie électroconductrice via l'unité d'électrodes (3, 4, 5) à la source de tension HF/VHF (6) ; un cadre de contact (12) est en outre relié par voie électroconductrice et mobile au blindage électrique (11) de manière à établir, lors du fonctionnement du dispositif, une liaison électroconductrice du cadre de contact (12) avec le porte-substrat (9).

2. Dispositif selon la revendication 1, **caractérisé en ce que** le cadre de contact (12) est pourvu sur le côté tourné dans la direction de l'espace de réaction au plasma (10) d'un couche non électroconductrice ou d'un revêtement non électroconducteur.

3. Dispositif selon la revendication 1 ou 2, **caractérisé en ce qu'**au moins un canal d'aspiration (13) pour les produits de réaction est raccordé à l'espace de réaction au plasma (10).

4. Dispositif selon la revendication 3, **caractérisé en ce que** le canal d'aspiration (13) débouche entre le blindage (11) et une paroi (1) de la chambre à vide.

5. Dispositif selon l'une quelconque des revendications précédentes, **caractérisé en ce que** l'unité d'électrodes est formée d'éléments individuels (3, 4, 5) en forme de plaques se touchant par la surface et reliés les uns aux autres.

6. Dispositif selon la revendication 5, **caractérisé en ce que** l'unité d'électrodes (3, 4, 5) est une partie de la paroi externe de la chambre à vide.

7. Dispositif selon la revendication 5 ou 6, **caractérisé en ce qu'**un élément externe (3) en forme de plaque est relié par voie électroconductrice à la source de tension HF/VHF (6) et séparé de la paroi restante (1) de la chambre à vide par une isolation (2) non électroconductrice.

8. Dispositif selon l'une quelconque des revendications 5 à 7, **caractérisé en ce qu'**une distribution de gaz avec des ouvertures de sortie de gaz est formée dans l'espace de réaction au plasma (10) avec au moins deux éléments (4 et 5) en forme de plaques et reliés l'un à l'autre de l'unité d'électrodes et en ce queles éléments (4 et 5) en forme de plaques sont reliés à l'élément externe (3) en forme de plaque.

9. Dispositif selon l'une quelconque des revendications précédentes, **caractérisé en ce que** l'élément en forme de plaque (3) est conformé en cuvette.

10. Dispositif selon l'une quelconque des revendications précédentes, **caractérisé en ce que** les éléments en forme de plaques (3, 4, 5) sont reliés les uns aux autres par le biais d'éléments de contact thermoconducteurs distribués de façon homogène sur la surface.

11. Dispositif selon l'une quelconque des revendications 5 à 10, **caractérisé en ce qu'**un dispositif d'équilibrage de température est agencé sur l'élément externe (3) en forme de plaque.

12. Dispositif selon la revendication 11, **caractérisé en ce que** le dispositif d'équilibrage de température est agencé à l'extérieur de la chambre à vide dans une zone à pression ambiante.

13. Dispositif selon l'une quelconque des revendications 5 à 12, **caractérisé en ce qu'**un ou plusieurs contacts de connexion électrique de la source de tension HF/VHF (6) est/sont agencé(s) sur l'élément externe (3) en forme de plaque à l'extérieur de la chambre à vide.

14. Dispositif selon l'une quelconque des revendications 5 à 13, **caractérisé en ce que** les éléments en forme de plaques (3, 4, 5) et/ou les éléments de contact thermoconducteurs sont formés d'un matériau de conductibilité thermique élevée.

15. Dispositif selon l'une quelconque des revendications 5 à 14, **caractérisé en ce que** les éléments de contact thermoconducteurs sont des rivets et/ou des vis.

16. Dispositif selon l'une quelconque des revendications 5 à 15, **caractérisé en ce que** les éléments de contact thermoconducteurs et les éléments en forme de plaques (3, 4, 5) de l'unité d'électrodes sont formés du même matériau.

17. Dispositif selon l'une quelconque des revendications 5 à 16, **caractérisé en ce que** sur l'unité d'électrodes (3, 4, 5), des éléments de contact thermoconducteurs et des ouvertures de sortie pour le gaz de réaction sont agencés respectivement à équidistance les uns des autres dans l'espace de réaction au plasma (10).
